# EUROPEAN PATENT APPLICATION

(11) **EP 2 015 140 A1**
(43) Date of publication of application: **14.01.2009**
(21) Application number: 08252279.8
(22) Date of filing: 04.07.2008
(51) Int. Cl.: G03F 7/20

(54) **Substrates and methods of using those substrates**

(30) Priority: 09.07.2007 US 822695
(71) Applicant: ASML Netherlands BV, 5504 DR Veldhoven (NL)
(72) Inventor: De Jong, Anthonius, Martinus, Cornelis, Petrus, 2642 CV Pijnacker (NL); Bouchoms, Igor, Petrus, Maria, 5501 GN Veldhoven (NL); Bruls, Richard Joseph, 5652 LD Eindhoven (NL); Jansen, Hans, 5653 PP Eindhoven (NL); Leenders, Martinus, Hendrikus, Antonius, 3161 JG Rhoon (NL); Wanten, Peter, Franciscus, 5731 HJ Mierlo (NL); Van Der Heijden, Marcus, Theodoor, Wilhelmus, 3650 Dilsen-Stokkem (Elen) (BE); Van Der Donck, Jacques Cor Johan, 2403 EA Alphen aan den Rijn (NL); Van Den Bogaard, Frederick Johannes, 5616 KB Eindhoven (NL); Groenewold, Jan, 1112 KG Diemen (NL); Van Der Graaf, Sandra, 6702 AH Wageningen (NL); Zoldesi, Carmen Julia, 5508 VM Veldhoven (NL)
(74) Representative: Roberts, Peter David

(57) **Abstract**

A substrate (CW1) suitable to remove contamination from an apparatus used in lithography, the substrate dimensioned so as to be suitable for handling by the lithographic apparatus, the substrate comprising:a rigid support layer (1); and a deformable layer (2) provided on the rigid support layer.

## Description

### FIELD

The present invention relates to a substrate and a method of using such a substrate.

### BACKGROUND

A lithographic apparatus is a machine that applies a desired pattern onto a target portion of a substrate. Lithographic apparatus can be used, for example, in the manufacture of integrated circuits (ICs). In that circumstance, a patterning device, which is alternatively referred to as a mask or a reticle, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the beam in a given direction (the "scanning"-direction) while synchronously scanning the substrate parallel or anti-parallel to this direction.

One of the biggest problems encountered in lithography is contamination. For example, contamination of the substrate may increase the number of defects in a pattern or a plurality of patterns on the substrate. Contamination on a lens element may make it difficult to accurately apply a pattern to the substrate. A further example of where contamination may be a problem is in immersion lithography. In immersion lithography, an immersion fluid is used to increase the numerical aperture of a projection system used in the lithographic apparatus. An immersion fluid may therefore be used between the final element of a projection system and the substrate itself. The immersion fluid may become contaminated by particles or flakes of resist or other materials which become separated from the substrate or from layers deposited on the substrate. Such contamination can make it difficult or impossible to accurately project a (patterned) radiation beam onto the substrate via the immersion fluid.

It is desirable to provide, for example, one or more substrates and one or more methods of using the one or more substrates which obviate or mitigate one or more of the problems of the prior art, whether identified herein or elsewhere.

According to a first aspect of the invention, there is provided a substrate suitable for removing contamination from an apparatus used in lithography, the substrate dimensioned so as to be suitable for handling by the lithographic apparatus, the substrate comprising: a rigid support layer; and a deformable layer provided on the rigid support layer.

The deformable layer may comprise a plurality of brushes. The deformable layer may comprise a plurality of fibers. The deformable layer may comprise a sponge. The deformable layer may comprise a polyvinyl alcohol sponge.

The deformable layer may be attached to the rigid support layer using an adhesive. The deformable layer may be fused to the rigid support layer.

The substrate may be substantially cylindrical in shape. The substrate may have a diameter of around 200 mm, or a diameter of around 300 mm. The depth of the substrate may be selected from the range of around 0.5 mm to around 3.5 mm.

The rigid support layer may be formed from quartz, silicon or a metal.

According to a second aspect of the invention, there is provided a method of removing contamination from an apparatus used in lithography, the method comprising: loading a substrate into the apparatus, the substrate comprising a rigid support layer and a deformable layer provided on the rigid support layer; bringing the deformable layer of the substrate into contact with a surface of the apparatus from which contamination is to be removed; introducing relative movement between the deformable layer and the surface of the apparatus from which contamination is to be removed to dislodge contamination from the surface for removal; and removing the dislodged contamination.

The deformable layer may retain at least a part of the dislodged contamination.

The substrate may be unloaded from the apparatus to remove the part of the dislodged contamination.

At least a part of the dislodged contamination may be removed using a fluid. The fluid may be an immersion fluid.

The apparatus may be an immersion hood of a lithographic apparatus.

According to a third aspect of the invention, there is provided a substrate suitable to remove contamination from an apparatus used in lithography, the substrate dimensioned so as to be suitable for handling by the lithographic apparatus, the substrate comprising: a first region and a second region configured to attract contamination, the second region having a different polarity or electrical charge to the first region, the first and second regions each being one of: polar and positively charged, polar and negatively charged, apolar and positively charged, or apolar and negatively charged.

The first region and the second region may be repeated across the substrate.

The substrate may comprise a third region having a different polarity or electrical charge to the first region and the second region, the third region being one of: polar and positively charged, polar and negatively charged, apolar and positively charged, or apolar and negatively charged. The first region, the second region and the third region may be repeated across the substrate.

The substrate may comprise a fourth region having a different polarity or electrical charge to the first region, the second region, and the third region, the fourth region being one of: polar and positively charged, polar and negatively charged, apolar and positively charged, or apolar and negatively charged. The first region, the second region, the third region and the fourth region may be repeated across the substrate.

The first region and the second region may form one of: a checkerboard pattern, an array of concentric rings, an array of rings, an array of ring segments, or an array of linear strips.

A polar and positively charged region may be provided by an amine functionalized silicon surface. A polar and negatively charged region may be provided by a silicon surface. An apolar and positively charged region may be provided by an amine functionalized HMDS (hexamethyldisilizane) treated silicon surface. An apolar and negatively charged region may be provided by a HMDS (hexamethyldisilizane) treated silicon surface.

According to a fourth aspect of the invention, there is provided a method of removing contamination from an apparatus used in lithography, the method comprising: loading a substrate into the apparatus to attract contamination onto the substrate, the substrate comprising a first region and a second region configured to attract contamination, the second region having a different polarity or electrical charge to the first region, the first and second regions each being one of: polar and positively charged, polar and negatively charged, apolar and positively charged, or apolar and negatively charged; and unloading the substrate from the apparatus.

The contamination may be removed from a fluid at least partly contained by the apparatus.

The method may comprise bringing the substrate into proximity or contact with the fluid from which contamination is to be removed. The method may further comprise introducing relative movement between the substrate and the fluid from which contamination is to be removed.

The apparatus may be an immersion hood of a lithographic apparatus.

The fluid may be an immersion fluid.

According to a fifth aspect of the invention, there is provided a method of removing contamination from an apparatus used in lithography, the method comprising: loading a first substrate into the apparatus to attract contamination onto the first substrate, the first substrate comprising a region configured to attract contamination and being one of: polar and positively charged, polar and negatively charged, apolar and positively charged, or apolar and negatively charged; unloading the first substrate from the apparatus; loading a second substrate into the apparatus to attract contamination onto the second substrate, the second substrate comprising a region configured to attract contamination and having a different polarity or electrical charge to the region of the first substrate, and being one of: polar and positively charged, polar and negatively charged, apolar and positively charged, or apolar and negatively charged; and unloading the second substrate from the apparatus.

The method may further comprise: loading a fourth substrate into the apparatus to attract contamination onto the fourth substrate, the substrate comprising a region configured to attract contamination and having a different polarity or electrical charge to the region of the first substrate, the region of the second substrate, and the region of the third substrate, the fourth region being one of: polar and positively charged, polar and negatively charged, apolar and positively charged, or apolar and negatively charged; and unloading the third substrate from the apparatus.

The contamination may be removed from a fluid at least partly contained by the apparatus. The method may comprise bringing the substrate into proximity or contact with the fluid from which contamination is to be removed. The method may further comprise introducing relative movement between the substrate and the fluid from which contamination is to be removed.

The apparatus may be an immersion hood of a lithographic apparatus.

The fluid may be an immersion fluid.

According to a sixth aspect of the invention, there is provided a substrate suitable to remove contamination from a fluid at least partly contained by an apparatus used in lithography, the substrate dimensioned so as to be suitable for handling by the lithographic apparatus, the substrate comprising a series of protrusions or recesses that are wetting or anti-wetting with respect to the fluid to promote the transfer of contamination from the fluid to the cleaning substrate.

The substrate may be formed from a material that is anti-wetting or wetting. The protrusions or recesses may be provided with an anti-wetting or wetting coating. The substrate may be provided with a layer of anti-wetting or wetting material that has been processed to form the series of protrusions or recesses. The series of protrusions or recesses may be anti-wetting or wetting with respect to an immersion fluid. The series of protrusions or recesses may be hydrophobic or hydrophilic. The substrate may comprise a series of recesses and protrusions, and the recesses and protrusions may be anti-wetting with respect to the fluid. The substrate may comprise a series of recesses and protrusions, and the recesses and protrusions may be wetting with respect to the fluid. The substrate may comprise a series of recesses and protrusions, and the recesses may be wetting with respect to the fluid and the protrusions may be anti-wetting with respect to the fluid. The substrate may comprise a series of recesses and protrusions, and the recesses may be anti-wetting with respect to the fluid and the protrusions may be wetting with respect to the fluid.

The series of protrusions may contain protrusions of different heights. The series of recesses may contain recesses of different depths.

The series of protrusions or recesses may form a regular pattern across the substrate. The series of protrusions or recesses may form an irregular pattern across the substrate.

The substrate may be substantially cylindrical in shape. The substrate may have a diameter of around 200 mm, or a diameter of around 300 mm. The depth of the substrate may be selected from the range of around 0.5 mm to around 3.5 mm.

According to a seventh aspect of the invention, there is provided a method of removing contamination from a fluid at least partly contained by an apparatus used in lithography, the method comprising: loading a substrate into the apparatus, the substrate comprising a series of protrusions or recesses, the series of protrusions or recesses being wetting or anti-wetting with respect to the fluid to promote the transfer of contamination from the fluid to the cleaning substrate; bringing the substrate into proximity with the fluid from which contamination is to be removed, such that the contamination is removed from the fluid and deposited onto the protrusions or into the recesses; and unloading the substrate from the apparatus.

The method may further comprise introducing relative movement between the substrate and the fluid from which contamination is to be removed.

The apparatus may be an immersion hood of a lithographic apparatus.

The fluid is an immersion fluid.

### BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus;

Figures 2A to 2C depict a substrate and use of that substrate in accordance with an embodiment of the present invention;

Figures 3A and 3B depict a substrate and the use of that substrate in accordance with an embodiment of the present invention;

Figures 4A to 4E depict substrates and uses of those substrates in accordance with an embodiment of the present invention; and

Figures 5A to 5D depict a substrate and use of that substrate in accordance with an embodiment of the present invention.

### DETAILED DESCRIPTION

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning device" used herein should be broadly interpreted as referring to a device that can be used to impart a radiation beam with a pattern in its cross-section such as to create a pattern in a target portion of the substrate. It should be noted that the pattern imparted to the radiation beam may not exactly correspond to the desired pattern in the target portion of the substrate. Generally, the pattern imparted to the radiation beam will correspond to a particular functional layer in a device being created in the target portion, such as an integrated circuit.

A patterning device may be transmissive or reflective. Examples of patterning device include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned.

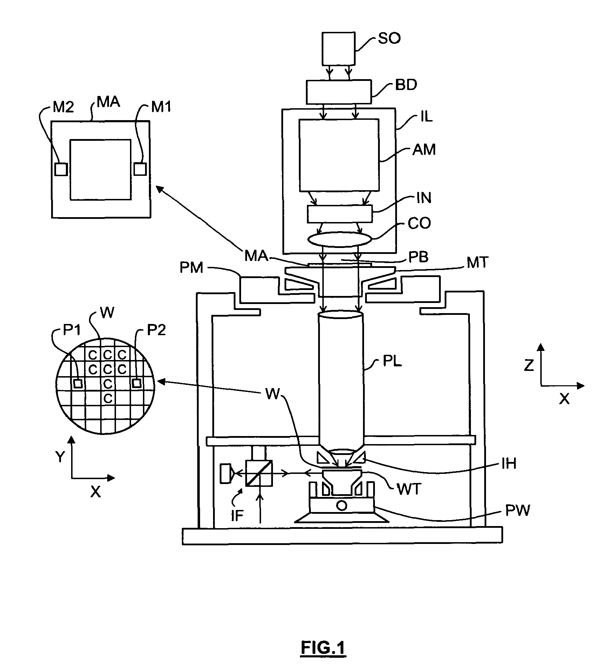

Figure 1 schematically depicts a lithographic apparatus. The apparatus comprises:

- an illumination system (illuminator) IL to condition a beam PB of radiation (e.g. UV radiation or EUV radiation);

- a support structure (e.g. a mask table) MT to support a patterning device (e.g. a mask) MA and connected to first positioning device PM to accurately position the patterning device with respect to item PL;

- a substrate table (e.g. a wafer table) WT to hold a substrate (e.g. a resist-coated wafer) W and connected to second positioning device PW to accurately position the substrate with respect to item PL;

- a projection system (e.g. a refractive projection lens) PL configured to image a pattern imparted to the radiation beam PB by patterning device MA onto a target portion C (e.g. comprising one or more dies) of the substrate W; and

- an immersion hood IH (sometimes referred to as an immersion head) to at least partly retain an immersion fluid (not shown) between the projection system PL and a part of the substrate W.

As here depicted, the apparatus is of a transmissive type (e.g. employing a transmissive mask). Alternatively, the apparatus may be of a reflective type (e.g. employing a programmable mirror array of a type as referred to above).

The support structure MT holds the patterning device. It holds the patterning device in a way depending on the orientation of the patterning device, the design of the lithographic apparatus, and other conditions, such as whether or not the patterning device is held in a vacuum environment. The support structure MT can use mechanical clamping, vacuum, or other clamping techniques, for example electrostatic clamping under vacuum conditions. The support structure MT may be a frame or a table, for example, which may be fixed or movable as required and which may ensure that the patterning device is at a desired position, for example with respect to the projection system. Any use of the terms "reticle" or "mask" herein may be considered synonymous with the more general term "patterning device".

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation PB, having a desired uniformity and intensity distribution in its cross-section.

The illumination system may also encompass various types of optical components, including refractive, reflective, and catadioptric optical components for directing, shaping, or controlling the beam of radiation, and such components may also be referred to below, collectively or singularly, as a "lens".

The radiation beam PB is incident on the patterning device (e.g. mask) MA, which is held on the support structure MT. Having traversed the patterning device MA, the beam PB passes through the lens PL, which focuses the beam onto a target portion C of the substrate W via an immersion fluid retained by the immersion hood IH. With the aid of the second positioning device PW and position sensor IF (e.g. an interferometric device), the substrate table WT can be moved accurately, e.g. so as to position different target portions C in the path of the beam PB. Similarly, the first positioning device PM and another position sensor (which is not explicitly depicted in Figure 1) can be used to accurately position the patterning device MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning device PM and PW. However, in the case of a stepper (as opposed to a scanner) the support structure MT may be connected to a short stroke actuator only, or may be fixed. Patterning device MA and substrate W may be aligned using patterning device alignment marks M1, M2 and substrate alignment marks P1, P2.

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "projection lens" herein may be considered as synonymous with the more general term "projection system".

The lithographic apparatus may be of a type having two (dual stage) or more substrate tables (and/or two or more support structures). In such "multiple stage" machines the additional tables and/or support structures may be used in parallel, or preparatory steps may be carried out on one or more tables and/or support structures while one or more other tables and/or support structures are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

The depicted apparatus can be used in one or more of the following modes:

1. In step mode, the support structure MT and the substrate table WT are kept essentially stationary, while an entire pattern imparted to the beam PB is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the beam PB is projected onto a target portion C (i.e. a single dynamic exposure). The velocity and direction of the substrate table WT relative to the support structure MT is determined by the (de-) magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the beam PB is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

As mentioned above, a problem encountered in lithography is contamination. The reduction and, where possible, the elimination of contamination of a part of the lithographic apparatus is desirable. For example, a reduction in contamination of elements of the lithographic apparatus may reduce the number of defects in a pattern or plurality of patterns projected onto a substrate. Ever decreasing wavelengths of radiation used to apply patterns to substrates means that contamination having smaller dimensions becomes even more of a problem. According to an embodiment of the present invention, a way to reduce the contamination of a part of the lithographic apparatus is to employ a substrate which has been specially treated and/or designed to remove contamination from the lithographic apparatus. Such a cleaning substrate may be passed through the lithographic apparatus (for example, apparatus to project radiation onto a substrate, a coating module, an oven, or any other apparatus used in lithographic processes) to reduce the contamination of the lithographic apparatus. Such a substrate may physically contact the surface on which contamination is to be reduced and/or removed, or may attract contaminants, thereby extracting them from the immediate environment. Such a cleaning substrate may be particularly useful for reducing contamination in a lithographic apparatus which employs an immersion fluid.

Contamination may be more prevalent in immersion lithography due to the nature of the processes involved. For example, it can be seen from Figure 1 that an immersion hood IH at least partly retains an immersion fluid between the projection system PL and the substrate W. Pressure is exerted on the top-side of a substrate W (that is, the side of a substrate W which is provided with, among other possible layers, a layer of resist) by the immersion hood IH and the immersion fluid which it retains. This pressure can cause part of the resist and/or other layer deposited on the substrate W to become loose, and even flake off. This can result in contamination of the immersion hood and/or the immersion fluid, possibly reducing the effectiveness of both.

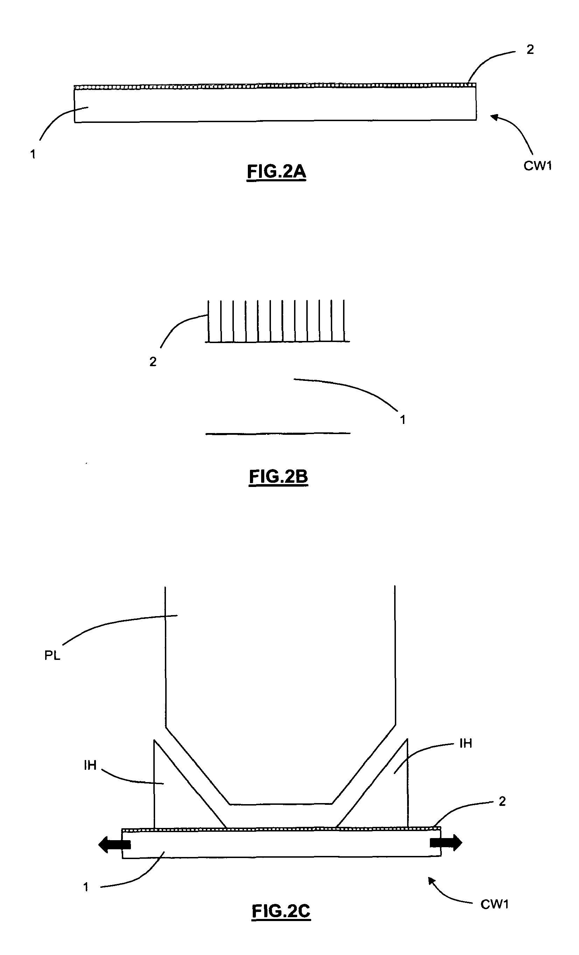

Figure 2A depicts a cleaning substrate CW1 in accordance with an embodiment of the present invention. The cleaning substrate CW1 comprises a standard substrate 1 which serves as a rigid support layer. The substrate 1 is standard in that it is the same width as those substrates which may be covered with a layer of resist and patterned using the lithographic apparatus of Figure 1 (e.g. the substrate maybe, for example, a 200 mm or 300 mm in diameter wafer substantially cylindrical in shape). Referring back to Figure 2A, the substrate 1 is provided with a layer of brushes 2. The layer of brushes 2 may be formed from a plurality of individual brushes, fibers, strands, etc. For example, the brushes, fibers or strands could be formed from PVA (polyvinyl alcohol) sponge. The brushes, fibers or strands forming the layer of brushes 2 may be so closely packed that the layer of brushes 2 effectively forms a continuous, unbroken layer. Alternatively, as shown in Figure 2B, the layer of brushes 2 may be less densely packed, so that the fibers from the layer 2 are not forming a continuous layer. Of course, the substrate surface may have a combination of both closely and less densely packed brushes 2 on different areas.

The layer of brushes 2 may be attached to the substrate 1 by heating of the substrate 1 such that the layer of brushes 2 fuses to the substrate 1. Alternatively or additionally, the layer of brushes 2 may be attached using any suitable adhesive, for example an acrylic-based pressure sensitive adhesive may be used. Such adhesives can be obtained, for example from 3M, Minnesota, U.S. A typical example is the 3M VHB adhesive. The substrate 1 itself may be formed from silicon, quartz, metal or any suitable material.

In use, the cleaning substrate CW1 may pass through a lithographic apparatus and/or other tool in such a way as to bring the layer of brushes 2 into contact with a contaminated surface. Bringing the layer of brushes 2 into contact with such a surface can be achieved by movement of the surface, and/or the cleaning substrate CW1, or by appropriate design of the size of the cleaning substrate CW1, for example the thickness of the substrate 1 and/or the layer of brushes 2. For example, a conventional substrate used in lithography may be around 1 mm thick. The lithographic apparatus is, where appropriate, designed to provide a degree of clearance between the substrate and elements of the lithographic apparatus. The combined thickness of the substrate 1 and/or layer of brushes 2 may be 0.5 mm - 3.5 mm, such that there is no clearance between the layer of brushes 2 and one or more elements of the lithographic apparatus (i.e. the layer of brushes 2 contacts the element(s)).

Figure 2C depicts an example of the use of the cleaning substrate CW1. An immersion hood IH is shown disposed below a projection system PL (for example, the immersion hood IH and projection system PL of Figure 1). The cleaning substrate CW1 is positioned such that the layer of brushes 2 is brought into contact with the immersion hood IH. Contamination on the lowermost surface of the immersion hood IH may be removed by moving the cleaning substrate CW1 relative to the immersion hood IH and/or moving the immersion hood IH relative to the cleaning substrate CW1.

Contamination may be absorbed by the material forming the layer of brushes 2, or contamination may become lodged on and/or in-between brushes of the layer 2. The layer of brushes 2 may also or alternatively dislodge contamination from the lowermost surface of the immersion hood IH. The dislodged contamination can be washed away by immersion fluid which may be retained by the immersion hood IH between the cleaning substrate CW1 and projection system PL. The layer of brushes 2 is desirably deformable, so as not to cause damage to the immersion hood IH.

By removing contamination from the lowermost surface of the immersion hood IH, the chances of this contamination becoming dislodged and contaminating the immersion fluid and/or a substrate being exposed to radiation via the projection system PL is reduced or eliminated.

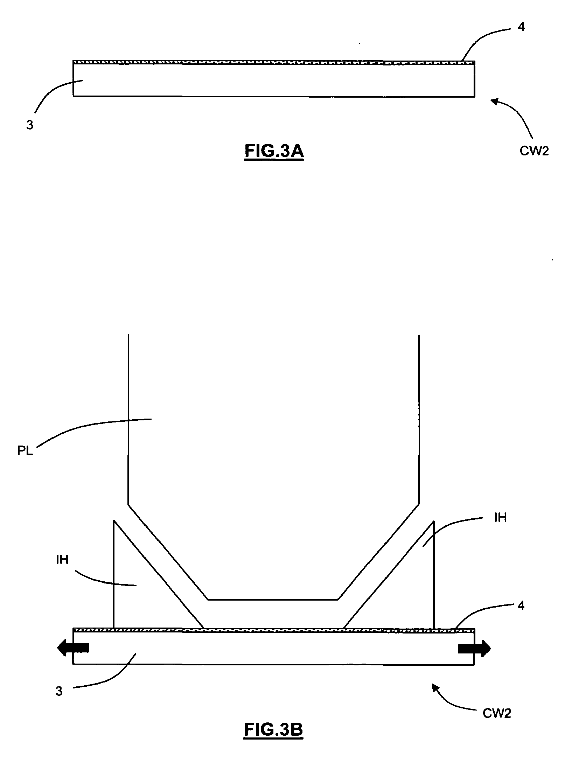

Figure 3A depicts a similar cleaning substrate to that of Figure 2A, and Figure 3B depicts a similar use of that substrate to the use illustrated in relation to Figure 2C. Figure 3A shows a cleaning substrate CW2 that comprises a substrate 3 which serves as a rigid support layer, upon which is provided a layer of sponge 4. The layer of sponge 4 may be attached to the substrate 3 using adhesive (for example, the adhesive described in relation to the cleaning substrate CW1 of Figure 2A) and/or by heating the substrate 3 such that the layer of sponge 4 partially melts on to and is bonded to the substrate 3.

The cleaning substrate CW2 may be of a standard size used in lithography. For example, the cleaning substrate CW2 may be a 200 mm in diameter, or a 300 mm in diameter, or any other size, wafer used in a lithographic apparatus, and may be substantially cylindrical in shape. This is so that the cleaning substrate CW2 can be loaded into and moved around a lithographic apparatus in the same way as a substrate provided with a layer of resist could be. The substrate 3 may be formed from any suitable material, for example silicon, quartz, metal, etc. The layer of sponge 4 may be formed from any suitable material. A particularly good material is PVA sponge. This sort of sponge is known to become very soft when wetted, and is good at removing contamination from surfaces. An alternative or additional material for the layer of sponge 4 is polyurethane.

In use, the cleaning substrate CW2 may pass through a lithographic apparatus and/or other tools in such a way as to bring the layer of sponge 4 into contact with a contaminated surface. Bringing the layer of sponge 4 into contact with such a surface can be achieved by movement of the surface, and/or the cleaning substrate CW2, or by appropriate design of the size of the cleaning substrate CW2, for example the thickness of the substrate 3 and/or the layer of sponge 4. For example, a conventional substrate used in lithography may be around 1 mm thick. The lithographic apparatus is, where appropriate, designed to provide a degree of clearance between the substrate and elements of the lithographic apparatus. The combined thickness of the substrate 3 and/or layer of sponge 2 may be 0.5 mm - 3.5 mm, such that there is no clearance between the layer of sponge 4 and one or more elements of the lithographic apparatus (i.e. the layer of sponge 4 contacts the element(s)).

Figure 3B depicts use of the cleaning substrate CW2 of Figure 3A. In Figure 3B, it can be seen that the cleaning substrate CW2 has been loaded into, for example, the lithographic apparatus of Figure 1. The position of the cleaning substrate CW2 is such that the sponge layer 4 is brought into contact with the lowermost surface of the immersion hood IH. Movement of the cleaning substrate CW2 relative to the immersion hood IH (or vice versa) causes the layer of sponge 4 to rub against the lowermost surface of the immersion hood IH and remove contamination from it. Contamination (for example flakes or particles) may become attached to the surface of the layer of sponge 4 or become lodged in pores in the surface or body of the layer of sponge 4. Alternatively or additionally, the layer of sponge 4 may dislodge contamination from the lowermost surface of the immersion hood IH. If an immersion fluid is retained by the immersion hood IH at the same time as the layer of sponge 4 is used on the immersion hood IH, the immersion fluid may wash away the contamination which has been dislodged. The layer of sponge 4 is desirably deformable, so as not to cause damage to the immersion hood IH.

When one or both of the cleaning substrates CW1, CW2 of Figures 2A and 3A have been used to clean the immersion hood IH, they can be re-used to clean the same immersion hood IH at a later stage or another immersion hood (or other apparatus). Before being reused, contamination removed from the immersion hood IH and deposited on to the layer of brushes 2, or layer of sponge 4 should be removed. This can be done by rinsing the layers 2, 4, or by another process. Alternatively, the layers 2, 4 can be stripped from the respective substrates which support them, and replaced with another clean layer. Alternatively, a new, replacement cleaning substrate could be used. Alternatively, a new layer 2, 4 could be superimposed over the contaminated layer.

Before one or both of the cleaning substrates CW1, CW2 of Figures 2A and 3A are used to clean the immersion hood IH, the layer of brushes 2 or layer of sponge 4 may be wetted with, for example, ultra pure water or the like. Wetting the layers 2, 4 may make them more deformable, and/or more useful in removing contamination from a surface (e.g., the lowermost surface of the immersion hood IH).

Although the cleaning substrates CW1, CW2 of Figures 2A and 3A have been described, in use, as cleaning an immersion hood IH, one or both of them may be used instead or additionally to clean another surface. Cleaning of another surface may be achieved in much the same way as the cleaning of the immersion hood IH. That is, the cleaning substrate CW1, CW2 can be moved into a position whereby the layer of brushes 2 or layer of sponge 4 is brought into contact with a surface such that the layer may rub against the surface and remove contamination from that surface.

Instead of or in addition to the cleaning substrates CW1, CW2 of Figures 2A and 3A comprising a layer of brushes or sponge, any suitable (deformable) layer or other structure (or structures) may be used.

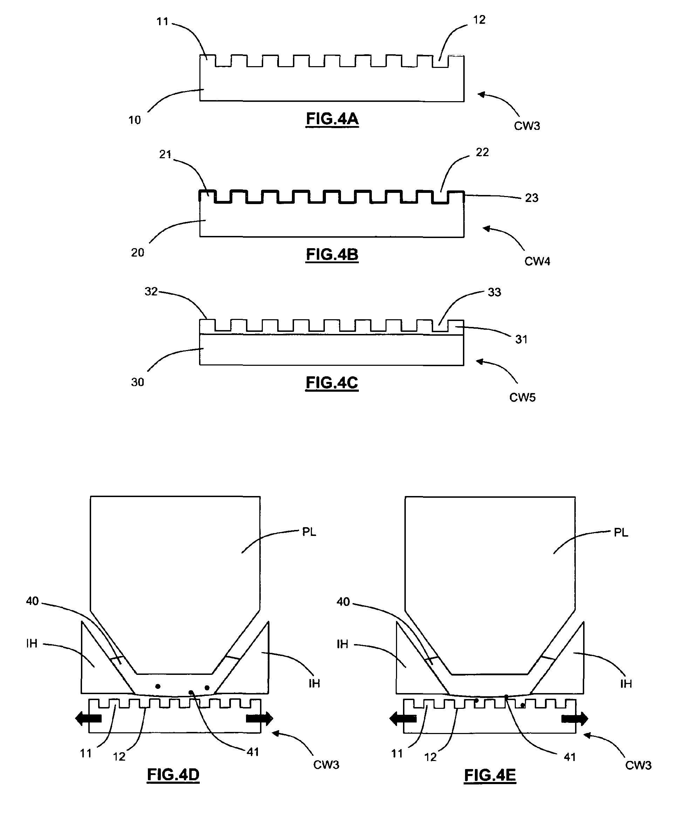

Figure 4A depicts a cleaning substrate CW3 that comprises a substrate 10 which has been provided with a patterned top-side. The pattern comprises a series of protrusions 11 and recesses 12. The substrate 10 is formed from a material which is anti-wetting with respect to an immersion fluid used in, for example, the lithographic apparatus of Figure 1, or is treated such that the protrusions 11 and recesses 12 are anti-wetting with respect to the immersion fluid.

Figure 4B depicts a further embodiment. Figure 4B shows a cleaning substrate CW4. In this embodiment, a substrate 20 has been provided with a series of protrusions 21 and recesses 22. In this embodiment, the series of protrusions 21 and recesses 22 are provided with a layer 23 which is anti-wetting with respect to the immersion fluid used. For example, the layer 23 may be a HMDS (hexamethyldisilizane) layer.

Figure 4C depicts a further embodiment. Figure 4C depicts a cleaning substrate CW5. In this embodiment, a substrate 30 has been provided with a layer 31 which is anti-wetting with respect to the immersion fluid. The layer 31 is provided with a series of protrusions 32 and recesses 33. The layer 31 maybe, for example, a HMDS layer.

The cleaning substrates of Figures 4A to 4C may be of a standard size used in lithography. For example, the cleaning substrates may be a 200 mm in diameter, or 300 mm in diameter, or any other size, wafer used in lithographic apparatus, and may be substantially cylindrical in shape. This is so that the cleaning substrate can be loaded into and moved around a lithographic apparatus in the same way as a substrate provided with a layer of resist could be.

In Figures 4A to 4C, the protrusions and recesses can be formed in any convenient manner, for example, using etching, exposure to radiation, or any process appropriate to the material used. Presently, ultra pure water has been proposed as the most suitable immersion fluid to be used in a lithographic apparatus such as show in Figure 1. If water is the immersion fluid, the surfaces or structures described above and which are referred to as being anti-wetting will be hydrophobic. Of course, if the immersion fluid is not water, the surfaces, and structures mentioned above and referred to as anti-wetting will be anti-wetting with respect to the alternative immersion fluid.

The substrates or layers on the substrates may be intrinsically anti-wetting (for example, HMDS is hydrophobic), or the substrates or layers may be treated to make them anti-wetting. For example, the substrates and/or layers may be exposed to a plasma to make them anti-wetting.

Figures 4D and 4E show use of the cleaning substrate CW3 of Figure 4A. However, it will be appreciated that the cleaning substrate CW4 and cleaning substrate CW5 may be used in the same way. Figure 4D shows the projection system PL and immersion hood IH of Figure 1. The immersion hood IH at least partly retains an immersion fluid 40 between the projection system PL and the cleaning substrate CW3. The cleaning substrate CW3 may be kept stationary relative to the immersion hood IH, or more desirably moved relative to the immersion hood IH (and/or the immersion hood IH moved relative to the cleaning substrate CW3). Small dots located in the immersion fluid 40 represent contamination 41. It can be seen that since the projections 11 and recesses 12 of the cleaning substrate CW3 are anti-wetting, and that the immersion fluid 40 does not flow into the recesses 12. Over time, the contamination 41 will flow or fall towards the cleaning substrate CW3. This may be due to gravity, or other forces such as van der Waals forces.

Figure 4E depicts a situation when the contamination 41 has fallen towards or flowed towards the cleaning substrate CW3. The contamination 41 may become attached to the cleaning substrate CW3 or fall into the recesses 12. The cleaning substrate CW3 may then be removed from the lithographic apparatus. The cleaning substrate CW3 could be cleaned of contamination such that it may be used to clean the same immersion hood IH at a later time or another immersion hood (or other apparatus). Alternatively for example, and depending upon how the cleaning substrate is constructed, layers deposited on the substrate may be stripped to remove the contamination. The layers can be replaced and the cleaning substrate reused.

The cleaning substrates of Figures 4A to 4C have been described as being provided with a series of protrusions and recesses that are anti-wetting with respect to the immersion fluid used. In another embodiment, the protrusions may be anti-wetting in nature and the recesses wetting in nature. In another embodiment, the protrusions may be wetting in nature and the recesses anti-wetting in nature. In another embodiment, the protrusions and recesses may both be wetting in nature. In summary, the recesses and/or protrusions should be appropriately wetting or anti-wetting to promote the transfer of contamination from the immersion fluid to the cleaning substrate.

Although the cleaning substrates of Figures 4A to 4C have been described in relation to the cleaning of an immersion hood and/or an immersion fluid, they may be used in other circumstances. For example, they may be used in particular where contamination is to be removed from any fluid. The fluid may be liquid or a gas.

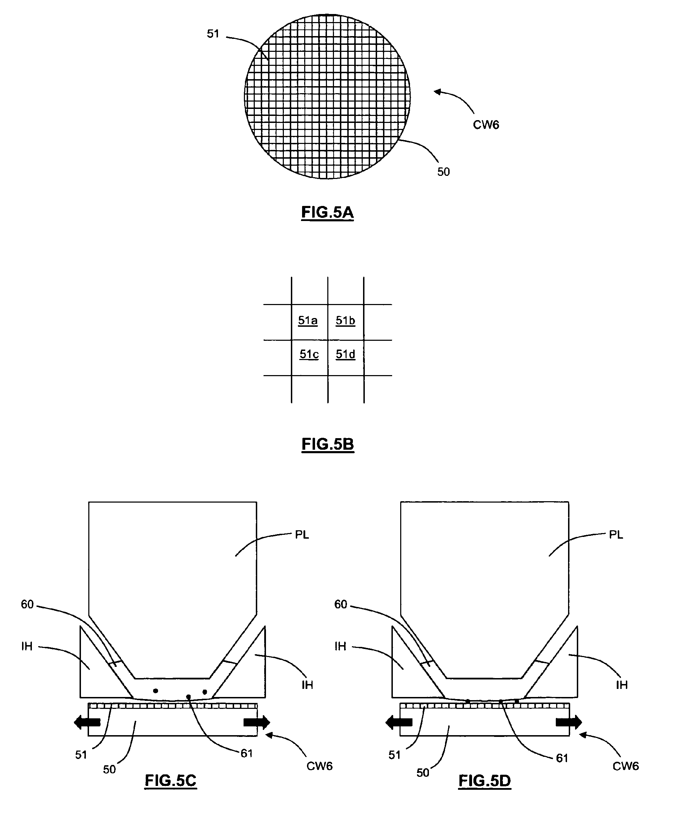

Figure 5A depicts a plan view of a cleaning substrate CW6. The cleaning substrate CW6 comprises a substrate 50 with a mosaic pattern 51. The mosaic pattern 51 may be provided directly into or onto the substrate 50, or may be provided into or onto one or more layers deposited on the substrate 50.

The cleaning substrate CW5 may be of a standard size used in lithography. For example, the cleaning substrate CW5 may be a 200 mm in diameter, or 300 mm in diameter, or any other size, wafer used in lithographic apparatus, and may be substantially cylindrical in shape. This is so that the cleaning substrate CW5 can be loaded into and moved around a lithographic apparatus in the same way as a substrate provided with a layer of resist could be. The substrate 50 may be formed from any suitable material, for example silicon, quartz, metal, etc.

Figure 5B depicts a section of the mosaic pattern 51 in more detail. Four individual pattern sections 51 a, 51 b, 51 c, 51 d are shown, and these four pattern sections are repeated across the substrate 50. Each pattern section 51 a, 51b, 51c, 51d is designed to attract particles of contamination of a specific nature. That is, a first pattern section 51 a may be arranged to attract particles of a positive electrical charge. A second pattern section 51 b may be arranged to attract particles of a negative electrical charge. A third pattern section 51 c may be arranged to attract particles of a polar nature. A fourth pattern section 51 d may be arranged to attract particles of an apolar nature. The pattern sections 51 a, 51b, 51 c, 51 d may be arranged to attract contamination having one of a combination of charges and polarities. A first pattern section 51 a may be arranged to attract polar contamination having a positive electrical charge. A second pattern section 51 b may be arranged to attract polar contamination having a negative charge. A third pattern section 51 c may be arranged to attract apolar contamination having a positive charge. A fourth pattern section 51 d may be arranged to attract apolar contamination having a negative charge. The pattern sections may attract neutral contamination (i.e. having no intrinsic electrical charge) by taking advantage of the zeta potential effect, where contamination having no intrinsic charge can take a negative or a positive surface charge that is impacted by the fluid that the contamination is immersed in. In water, for example, the ion type and concentration and more specifically the acidic or alkaline nature (i.e. pH value) influence the zeta potential.

The pattern sections can be formed from any suitable material (or be treated in any suitable way) to attract particles of a desired nature. For example, the first pattern section 51a could be bare silicon (for example, an exposed region of the substrate 50 itself). This section would have a negative charge and be a polar surface. It would therefore attract polar contamination having a positive charge. The second pattern section 51b could be amine functionalized silicon. This section would have a positive charge and be a polar surface. This section would therefore attract polar contamination having a negative charge. The third pattern section 5 1 c could be HMDS treated silicon. This section would therefore have a negative charge and be an apolar surface. This section would therefore attract apolar contamination having a positive charge. The fourth section 51d could comprise HMDS treated silicon, which has been amine functionalized. This section would therefore be positively charged and an apolar surface. This section would therefore attract apolar contamination having a negative charge.

The first, second, third and fourth pattern sections 51a, 51b, 51c, 51d could be arranged in any suitable manner, for example a mosaic (e.g. checkerboard) pattern, an array of concentric rings, rings, ring segments, an array of linear strips running across the substrate 50 or any convenient pattern.

Figure 5C shows the projection system PL and immersion hood IH of the lithographic apparatus of Figure 1. The immersion hood IH at least partly retains an immersion fluid 60 between the projection system PL and the cleaning substrate CW6. It can be seen that the immersion fluid 60 contains contamination 61. The cleaning substrate CW6 is desirably moved relative to the immersion hood IH and immersion fluid 60 (and/or vice versa) in order to expose a large area of the pattern 51 to the immersion hood IH and the immersion fluid 60.

Figure 5D shows what happens over time when the immersion fluid 60 and the contamination 61 which it contains is in close proximity with the cleaning substrate CW6. It can be seen that due to the nature of the pattern surface 51 (described in relation to Figures 5A and 5B) the contamination has been attracted to the pattern surface 51. The cleaning substrate CW6 can, after a period of time, be removed from being in proximity with the immersion fluid 60 and immersion hood IH. The cleaning substrate CW6 can then be cleaned to remove the contamination 61 from its pattern surface 51. The cleaning process may, for example, remove the contamination from the pattern surface, or alternatively, remove the pattern surface 51 itself. The pattern surface can be, if appropriate, reapplied to the substrate 50, or another cleaning substrate could be used.

Four different repeating pattern sections have been described, but other arrangements may be used. For example, two pattern sections having different electrical properties (e.g. charge and polarity) may be used, or even three pattern sections. The number of pattern sections may depend on the contamination which is intended to be removed from the surfaces or fluid used in the lithographic apparatus (or other tools).

Instead of providing a cleaning substrate with a mosaic pattern 51 having different electrical properties, the same general principle can be applied but using multiple substrates. For example, instead of providing a single substrate with a plurality of pattern sections having different electrical properties, the substrate may only be provided with a section having a single combination of electrical properties. A plurality of substrates could each be provided with a single section having a different set of electrical properties or a combination of electrical properties. These substrates can be passed successively through the lithographic apparatus to clean, for example, the immersion hood and/or immersion fluid. For example, a first substrate could be provided with a bare silicon surface as described above. A second substrate could be provided with an amine functionalized silicon surface, as described above. A third substrate could be provided with a HMDS treated silicon layer, as described above. A fourth substrate could be provided with a HMDS treated silicon layer which has been amine functionalized, as described above. Although the process of using this plurality of substrates to clean the immersion hood and/or immersion fluid will work, it may not be the most efficient method. For example, different substrates will need to be successively passed through the apparatus in order to clean it, whereas the substrate described in relation to Figures 5A and 5B may only need to be passed through the apparatus once since it is provided with a plurality of sections having different electrical properties. Thus, the removal of contamination from the lithographic apparatus may be achieved more quickly using a substrate having two or more sections each having different electrical properties for attracting contamination of different natures.

All of the cleaning substrates mentioned above may be used specifically and solely as cleaning substrates. However, these substrates may also have other purposes and/or functions. For example, the cleaning functionality described above can be introduced into a substrate which is normally used for chuck temperature control, or any other purpose. For example, the cleaning properties described above can be introduced to a reference substrate which is used to align the substrate table, support structure, etc. of the lithographic apparatus.

It will be appreciated that the cleaning substrates described above, can be used at any appropriate time. For example, the cleaning substrates could be used prior to each and every exposure of a substrate covered with resist. However, this may not be ideal, since throughput may be adversely affected. It may be more desirable to undertake a cleaning process using one or more of the substrates described above before a lot of (e.g. batch) of substrates covered with resist are exposed to the radiation beam.

As already described above, the cleaning substrates may be reused, for example, after appropriate cleaning which may involve stripping the cleaning substrate of layers, etc. which have been contaminated. Alternatively, the cleaning substrate can be disposed of and a new cleaning substrate used to clean a part of lithographic apparatus. Alternatively, a new layer, etc. may be provided over an existing contaminated layer, etc. on the cleaning substrate.

In the embodiments described above, the protrusions and recesses are shown in the Figures as being uniform. Alternatively, the protrusions and recesses may vary in height and depth across the surface of the substrate. Having different height protrusions and recesses may increase turbulent flow of air or immersion fluids, leading to increased efficiency for the removal of contamination from surfaces or the immersion fluid. The height of the protrusions or depths of the recesses should not be such that the protrusions and/or recesses are structurally unstable. As a general rule, the feature used to form the protrusion or recess should be no more than five times the width of the feature. The pitch of the protrusions and recesses is defined as the width of a protrusion plus the width of an adjacent recess. The pitch may vary between 50 nm and 1000 nm. The pitch may be varied to preferentially favour the deposition (or in other words, the collection) of contamination in the recesses. It will also be appreciated that the use of column-like recesses and protrusions is given by way of example only. The protrusions and recesses may be anything which can retain contamination. For example, the protrusions and recesses can be formed from scratching the surface of a substrate, for example using chemical or mechanical polishing. The pattern does not need to be regular, and an irregular pattern may be desired in that it may increase the turbulence of air and/or immersion fluid thereby increasing the efficiency of removal of contamination.

At any one time or successively, more than one cleaning substrate may be used. For example, one cleaning substrate may be used in one part of the lithographic apparatus when another substrate is used in another part of the lithographic apparatus. For example, a lithographic apparatus may work by exposing one substrate to radiation, while another substrate is scanned to determine its topography. A cleaning substrate could be used to clean the areas in and around these two stages.

One or more aspects of one of more of the cleaning substrates described herein may be used in combination on a single substrate. For example, a cleaning substrate may include a layer of brushes and a layer of sponge or a cleaning substrate may include a layer of brushes and an arrangement of the protrusions and recesses described above. Further, the cleaning substrates herein have been mostly depicted as having cleaning functionality on one side of the substrate. Cleaning functionality could be provided on one or more other sides of the substrate to provide further cleaning (e.g., cleaning at the same time of the immersion hood IH and the substrate table WT on which the cleaning substrate is supported to clean the immersion hood IH) or to provide a "clean" surface to be used in cleaning when the other surface is contaminated after use.

As mentioned above, the cleaning substrates described may be used to clean any appropriate surface of a lithographic apparatus. The cleaning substrates may even be used outside of the field of lithography. However, the cleaning substrates mentioned above are suited to use in lithography and in particular immersion lithography where contamination of the immersion hood and/or immersion fluid is a considerable problem, and one that is likely to increase in the future with the use of ever decreasing exposure wavelengths. A significant advantage of using a cleaning substrate to clean apparatus used in lithography is that the apparatus is already configured to handle substrates. This means that the apparatus can be cleaned by the cleaning substrate without having to open or at least partially dismantle the apparatus, which could otherwise allow further contamination to enter the apparatus.

While specific embodiments of the invention have been described above, it will be appreciated that the invention may be practiced otherwise than as described. The description is not intended to limit the invention.

## Claims

1. A substrate suitable to remove contamination from an apparatus used in lithography, the substrate dimensioned so as to be suitable for handling by the lithographic apparatus, the substrate comprising:
a rigid support layer; and
a deformable layer provided on the rigid support layer.

2. The substrate of claim 1, wherein the deformable layer comprises a plurality of brushes, or a plurality of fibers, or sponge or polyvinyl alcohol sponge.

3. The substrate of claim 1 or claim 2, wherein the deformable layer is attached to the rigid support layer using an adhesive.

4. The substrate of claim 1 or claim 2, wherein the deformable layer is fused to the rigid support layer.

5. The substrate of any preceding claim, wherein the depth of the substrate is selected from the range of around 0.5 mm to around 3.5 mm.

6. A method of removing contamination from an apparatus used in lithography, the method comprising:
loading a substrate into the apparatus, the substrate comprising a rigid support layer and a deformable layer provided on the rigid support layer;
bringing the deformable layer of the substrate into contact with a surface of the apparatus from which contamination is to be removed;
introducing relative movement between the deformable layer and the surface of the apparatus from which contamination is to be removed to dislodge contamination from the surface for removal; and
removing the dislodged contamination.

7. A substrate suitable to remove contamination from an apparatus used in lithography, the substrate dimensioned so as to be suitable for handling by the lithographic apparatus, the substrate comprising:
a first region and a second region configured to attract contamination, the second region having a different polarity or electrical charge to the first region, the first and second regions each being one of:
polar and positively charged,
polar and negatively charged,
apolar and positively charged, or
apolar and negatively charged.

8. The substrate of claim 7, wherein the first region and the second region are repeated across the substrate.

9. The substrate of claim 7 or claim 8, wherein the substrate comprises a third region having a different polarity or electrical charge to the first region and the second region, the third region being one of:
polar and positively charged,
polar and negatively charged,
apolar and positively charged, or
apolar and negatively charged.

10. The substrate of claim 9, wherein the first region, the second region and the third region are repeated across the substrate.

11. The substrate of claim 9 or claim 10, wherein the substrate comprises a fourth region having a different polarity or electrical charge to the first region, the second region, and the third region, the fourth region being one of:
polar and positively charged,
polar and negatively charged,
apolar and positively charged, or
apolar and negatively charged.

12. The substrate of claim 11, wherein the first region, the second region, the third region and the fourth region are repeated across the substrate.

13. The substrate of any of claims 7 to 12, wherein the first region and the second region form one of: a checkerboard pattern, an array of concentric rings, an array of rings, an array of ring segments, or an array of linear strips.

14. The substrate of any of claims 7 to 13, wherein a polar and positively charged region is provided by an amine functionalized silicon surface.

15. The substrate of any of claims 7 to 14, wherein a polar and negatively charged region is provided by a silicon surface.

16. The substrate of any of claims 7 to 15, wherein an apolar and positively charged region is provided by an amine functionalized HMDS (hexamethyldisilizane) treated silicon surface.

17. The substrate of any of claims 7 to 16, wherein an apolar and negatively charged region is provided by a HMDS (hexamethyldisilizane) treated silicon surface.

18. A method of removing contamination from an apparatus used in lithography, the method comprising:
loading a substrate into the apparatus to attract contamination onto the substrate, the substrate comprising a first region and a second region configured to attract contamination, the second region having a different polarity or electrical charge to the first region, the first and second regions each being one of:
polar and positively charged,
polar and negatively charged,
apolar and positively charged, or
apolar and negatively charged; and
unloading the substrate from the apparatus.

19. A method of removing contamination from an apparatus used in lithography, the method comprising:
loading a first substrate into the apparatus to attract contamination onto the first substrate, the first substrate comprising a region configured to attract contamination and being one of:
polar and positively charged,
polar and negatively charged,
apolar and positively charged, or
apolar and negatively charged;
unloading the first substrate from the apparatus;
loading a second substrate into the apparatus to attract contamination onto the second substrate, the second substrate comprising a region configured to attract contamination and having a different polarity or electrical charge to the region of the first substrate, and being one of:
polar and positively charged,
polar and negatively charged,
apolar and positively charged, or
apolar and negatively charged; and
unloading the second substrate from the apparatus.
